# EUROPEAN PATENT APPLICATION

(11) **EP 2 077 578 A1**
(43) Date of publication of application: **08.07.2009**
(21) Application number: 07828000.5
(22) Date of filing: 07.11.2007
(51) Int. Cl.: H01L 21/56, G01N 21/956, H01L 21/304

(54) **Dicing device for electronic component separation**

(30) Priority: 20.12.2006 JP 2006342180
(71) Applicant: Towa Corporation, Kyoto-shi, Kyoto 601-8105 (JP)
(72) Inventor: AMAKAWA, Tsuyoshi, Kyoto-shi Kyoto 601-8105 (JP)
(74) Representative: Hoeger, Stellrecht & Partner Patentanwälte
(86) International application number: PCT/JP2007/001222
(87) International publication number: WO 2008/075446

(57) **Abstract**

Regarding a singulation apparatus for singulating a resin encapsulated substrate to manufacture an electronic component, the present invention brings about shortening the delivery period, reducing the footprint, and reducing the cost inc compliance with a specification requested by a user. A singulation apparatus S2 for an electronic component has: a basic unit including a receiving unit A, singulation unit B, and delivery unit C; a cleaning unit D mounted between the singulation unit B and the delivery unit C; and an examination unit E mounted on the cleaning unit D. The singulation unit B is appropriately selected in accordance with the requested specification by the user, and a cutting mechanism used in the singulation unit B has a rotary blade 7, water jet, laser light, wire saw, band saw, etc. The cleaning unit D and examination unit E, both mounted on the basic unit, are each appropriately selected and mounted in accordance with the requested specification by the user. The cleaning unit D and examination unit E are mounted on the basic unit which has the singulation unit B in accordance with the requested specification by the user to form the singulation apparatus S2 for an electronic component.

## Description

### TECHNICAL FIELD

The present invention relates to a singulation apparatus for manufacturing an electronic component. The singulation apparatus is used for manufacturing a plurality of electronic components by resin-encapsulating semiconductor chips or other elements, each mounted on each of a plurality of areas provided on a substrate, to form a resin encapsulated substrate, and then singulating the resin encapsulated substrate by each area (i.e. dividing the substrate into pieces corresponding to the aforementioned areas).

### BACKGROUND ART

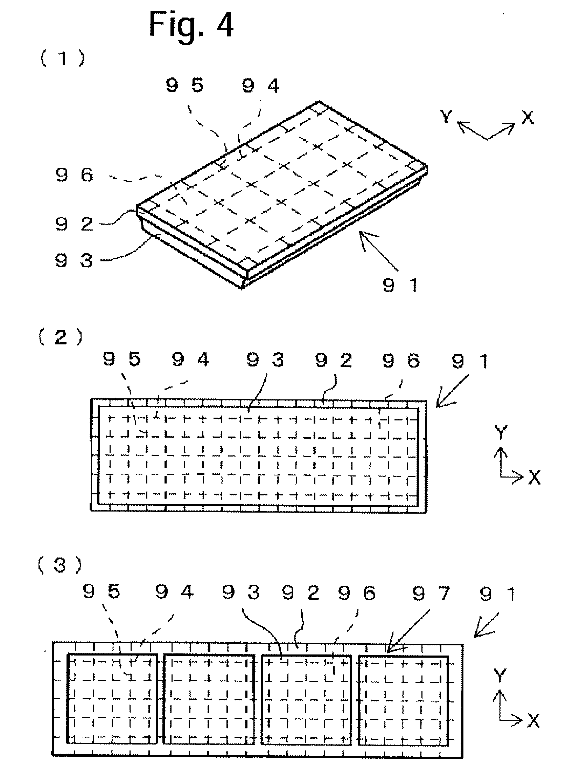

One conventional and established method for effectively manufacturing a plurality of electronic components is a method of singulating a resin encapsulated substrate. A resin encapsulated substrate, which is to be singulated in manufacturing an electronic component, is explained with reference to Fig. 4. Fig. 4(1) is a perspective view of a resin encapsulated substrate, which is to be singulated, viewed from the substrate side and schematically illustrated. Fig. 4(2) is an example of a resin encapsulated substrate and Fig. 4(3) is another example of a substrate, each illustrated as a plain view viewed from the encapsulating resin side. Every figure contained in the present application is schematically illustrated with an appropriate omission or exaggeration in order to make it clearly understood.

As illustrated in Fig. 4, a resin encapsulated substrate 91 includes a substrate 92 made of a lead frame, a print-circuit board, or other components, and an encapsulating resin 93 formed on one side of the substrate 92. The substrate 92 is sectioned into a plurality of grid areas 96 by boundary lines 94 in the X-direction and boundary lines 95 in the Y-direction each of which is virtually formed. On each area 96, a chip-like component such as a semiconductor chip (not shown) is mounted.

In recent years, demands for the price reduction and downsizing of electronic components have been increasing the size of the substrate 92. Further, the yield of the electronic components in substrate 92, i.e., the number of regions 96 tends to increase (refer to Fig. 4(2)). In some cases, in response to a request for preventing the resin encapsulated substrate 91 from warping, a plurality of island sections 97 each including a plurality of the areas 96 and an independent portion composed of the encapsulating resin 93 are formed on the resin encapsulated substrate 91 (refer to Fig. 4(3)). As just described, the resin encapsulated substrate 91 has come to have a variety of specifications in recent years.

The method for manufacturing a plurality of electronic components using the resin encapsulated substrate 91 will be described. First, a chip-like component (which will be called "a chip" hereinafter) is mounted on each of the plural areas 96 provided on the substrate 92. Next, a plurality of chips mounted on the substrate 92 are collectively resin-encapsulated by the encapsulating resin 93. This completes the resin encapsulated substrate 91. Next, the resin encapsulated substrate 91 is cut (or singulated) along the boundary lines 94 and 95. This makes the resin encapsulated substrate 91 singulated into a plurality of electronic components each of which corresponds to each of the areas 96. A singulated electronic component having the encapsulating resin 93 is often called a package.

Recently, the specification of the substrate 92 has been diverse. Concretely speaking, the material of the base member of the substrate 92 has been varied such as metal, glass epoxy, polyimide film, and ceramic. Also, the specification of the package has been diverse. Examples of the packages that have been adopted to date include a package having a plurality of layered chips, a photoelectron component package having an encapsulating resin made of a translucent resin, and many others.

In the process of cutting (or singulating) the resin encapsulated substrate 91, what is called a singulation apparatus is used, for example, such as a cutoff apparatus (or a dicer) using a rotary blade or a cutoff apparatus using a laser light. A singulation apparatus has three basic components: a receiving unit for receiving a resin encapsulated substrate which has been formed in the previous process (or resin-encapsulating process); a singulation unit for singulating the resin encapsulated substrate; and a delivery unit for delivering a plurality of electronic components (or packages) obtained by singulation into the subsequent process (e.g. a packaging process).

According to necessity, a singulation apparatus may include the following components such as: a cleaning unit for cleaning an aggregate composed of a plurality of singulated electronic components (or packages), an examination unit for examining each cleaned package, and a marking unit for marking the surface of the package in accordance with the examination result (refer to Patent Document 1 for example).

Each of the aforementioned components and each component in Patent Document 1 roughly corresponds to each other as follows: "substrate load unit A" in Patent Document 1 corresponds to the receiving unit, "cutting mechanism C" to the singulation unit, "cleaning and drying mechanism D" to the cleaning unit, "examination mechanism E" to the examination unit, and "package reception unit F" to the delivery unit, respectively.

[Patent document 1] Japanese Unexamined Patent Application Publication No. 2004-207424 (Page 3, Fig. 1)

### DISCLOSURE OF THE INVENTION

### PROBLEMS TO BE SOLVED BY THE INVENTION

However, conventional techniques as previously described have problems due to designing and manufacturing the singulation apparatus in accordance with the user-requested specifications regarding the substrate 92, the resin encapsulated substrate 91, package, etc. There are three difficult problems: firstly, shortening the delivery period, secondly, reducing the footprint (i.e. planer installation area) of the singulation apparatus, and thirdly, reducing the cost of the singulation apparatus.

Such problems have become overwhelming in connection with the further diversification of the specification of the substrate 92, the resin encapsulated substrate 91, package, etc. Concretely speaking, with the diversification of the specification of the substrate 92, the resin encapsulated substrate 91, package, etc, the user-requested specifications for the singulation apparatus have become diverse. In manufacturing a singulation apparatus, based on the specifications requested by each user, the specifications of the "cutting mechanism C," "cleaning and drying mechanism D," "examination mechanism E," and other units in Patent Document 1 are determined to manufacture a singulation apparatus in which each mechanism is incorporated. This condition even more escalates the aforementioned problems, i.e. the difficulty of shortening the delivery period, reducing the footprint, and reducing the cost.

Thus, the present invention is intended to address the difficulty of shortening the delivery period, reducing the footprint, and reducing the cost in manufacturing a singulation apparatus in compliance with the user-requested specification.

### MEANS FOR SOLVING THE PROBLEMS

The numbers in parenthesis in the following explanation signify the numerals in the figures, and are described with the aim of establishing an easy comparison between the words in the specification and the components in the figures. It should be noted that these numbers do not indicate that "the words in the specification are to be limitedly interpreted as the components illustrated in the figures."

To solve the aforementioned problems, the present invention provides a singulation apparatus for manufacturing an electronic component (S1 through S3), the singulation apparatus being used for manufacturing a plurality of electronic components by resin-encapsulating semiconductor chips or other elements each mounted on each of a plurality of areas provided on a substrate to form a resin encapsulated substrate (3) and then singulating the resin encapsulated substrate (3) by each area, including as compositional units:
a receiving unit (A) for receiving the resin encapsulated substrate (3);
a singulation unit (B) for singulating the resin encapsulated substrate (3); and
a delivery unit (C) for delivering the plurality electronic components formed by singulation,
wherein each of the receiving unit (A), the singulation unit (B), and the delivery unit (C) is attachable, detachable, and exchangeable with other compositional units.

The singulation apparatus for manufacturing an electronic component (S2 and S3) according to the present invention may include, as a compositional unit, a cleaning unit (D) for cleaning an aggregate (9) composed of a plurality of singulated electronic components, and the cleaning unit (D) may be attachable, detachable, and exchangeable with other compositional units.

The singulation apparatus for manufacturing an electronic component (S2 and S3) according to the present invention may include, as a compositional unit, an examination unit (E) for examining each of the plurality of the singulated electronic components, and the examination unit (E) may be attachable, detachable, and exchangeable with other compositional unit.

The singulation apparatus for manufacturing an electronic component (S1 through S3) according to the present invention may include a main conveying mechanism, which is placed at a position to be commonly applied to at least a portion of the compositional units (A through E), for conveying the resin encapsulated substrate (3) or the aggregate (9).

The singulation apparatus for manufacturing an electronic component (S 1 through S3) according to the present invention may be **characterized in that:**
the singulation unit (B) includes a cutting mechanism using any one of a rotary blade (7), laser light, water jet, wire saw, and band saw; and
one or a plurality of the singulation units (B) are included.

### EFFECTS OF THE INVENTION

The present invention includes the receiving unit (A), the singulation unit (B), and the delivery unit (C), and it may further include the cleaning unit (D) and the examination unit (E). Each compositional unit is attachable, detachable, and exchangeable with other compositional units. This allows an optimum singulation apparatus (S1 through S3) in accordance with the user-requested specification, in particular a singulation apparatus (S1) having an optimum singulation unit (B), receiving unit (A), and delivery unit (C), to be manufactured in a short period of time. In addition, a singulation apparatus (S2 and S3) having an optimum cleaning unit (D) and examination unit (E) in addition to these compositional units (A through C) is manufactured in a short period of time. Furthermore, since a main conveying mechanism is provided at a position to be commonly applied to a portion of the compositional units (A through E), a singulation apparatus (S1 through S3) can be manufactured in a short period of time also in view of this configuration. These configurations enable the singulation apparatus (S 1 through S3) optimum for the user to be delivered in a shorter period of time.

The present invention includes the receiving unit (A), the singulation unit (B), and the delivery unit (C), and each compositional unit also including the cleaning unit (D) and the examination unit (E) is attachable, detachable, and exchangeable with other compositional units. Therefore, unnecessary portions for the user are not included in the singulation apparatus (S1 through S3). Hence, reducing the footprint and cost of the singulation apparatus (S1 through S3) becomes possible. In addition, after the singulation apparatus (S 1 through S3) is delivered, each of the compositional units (A through E) can be replaced by or changed to a compositional unit with a different specification in accordance with the change in the market trends and technology trends, the user's demands, etc. Consequently, optimum singulation apparatuses (S1 through S3) corresponding to the change in the market trends and technology trends, the user's demands, etc, are realized.

In the present invention, the singulation unit (B) includes a cutting mechanism using any one of a rotary blade (7), laser light, water jet, wire saw, and band saw; and one or a plurality of the singulation units (B) are included. Simultaneously, the singulation unit (B) is attachable, detachable, and exchangeable with other compositional units (A through E). This brings about the following effects: firstly, a singulation apparatus (S1 through S3) having an optimum cutting mechanism can be obtained. Secondly, providing a plurality of singulation units (B) enhances the efficiency of singulating. Thirdly, providing a plurality of singulation units (B) permits the use of an optimum cutting mechanism in accordance with the property of the resin encapsulated substrate (3). Fourthly, providing a plurality of singulation units (B) permits a finishing processing. Hence, it is possible to enhance the cutting quality.

### BRIEF DESCRIPTION OF THE DRAWINGS

Fig. 1 is a schematic plain view illustrating the singulation apparatus for manufacturing an electronic component according to the first embodiment of the present invention.
Fig. 2 is a schematic plain view illustrating the singulation apparatus manufacturing an electronic component according to the second embodiment of the present invention.
Fig. 3 is a schematic plain view illustrating the singulation apparatus manufacturing an electronic component according to the third embodiment of the present invention.
Fig. 4(1) is a perspective view schematically illustrating a resin encapsulated substrate to be singulated viewed from the substrate side, Fig. 4(2) is a plain view of an example of the resin encapsulated substrate viewed from the encapsulating resin side, and Fig. 4(3) is that of another example of the resin encapsulated substrate.

### EXPLANATION OF NUMERALS

A Receiving Unit
B Singulation Unit
C Delivery Unit
D Cleaning Unit
E Examination Unit
F Option Unit
S1, S2, S3 Singulation Apparatus
1 Basic Unit
2 Pre-Stage
3 Resin Encapsulated Substrate
4 Cutting Table
5 Cutting Stage
6 Spindle
7 Rotary Blade
8 Tray
9 Aggregate
10 Cleaning Mechanism
11 Cleaning Roller
12 Examination Table
13 Examination Stage
14 Camera

### BEST MODES FOR CARRYING OUT THE INVENTION

A singulation apparatus (S2) for an electronic component includes; a basic unit (1) including a receiving unit (A), a singulation unit (B), and a delivery unit (C); a cleaning unit (D) mounted between the singulation unit (B) and the delivery unit (C); and an examination unit (E) mounted on the cleaning unit (D). The singulation unit (B) is appropriately selected in accordance with a requested specification by the user. As a cutting mechanism that the singulation unit (B) has, a rotary blade (7), water jet, laser light, wire saw, band saw, etc, is selected and used according to the requested specification by the user. The cleaning unit (D) and the examination unit (E) mounted on the basic unit (1) are each appropriately selected and mounted in accordance with the requested specification by the user. The cleaning unit (D) and the examination unit (E) are mounted, in accordance with the requested specification by the user, on the basic unit (1) including the receiving unit (A), the singulation unit (B), and the delivery unit (C) to form the singulation apparatus (S2) for an electronic component.

### FIRST EMBODIMENT

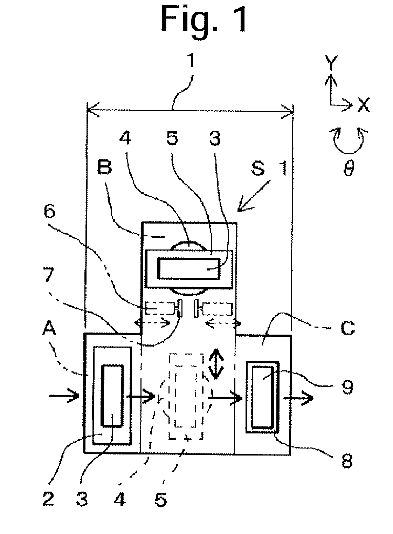

The first embodiment of the singulation apparatus for manufacturing an electronic component according to the present invention will be described with reference to Fig. 1. Fig. 1 is a schematic plain view illustrating the singulation apparatus for manufacturing an electronic component according to this embodiment. A singulation apparatus S1 illustrated in Fig. 1 is a singulation apparatus for singulating a resin encapsulated substrate into a plurality of electronic components. As illustrated in Fig.1, the singulation apparatus S1 has a receiving unit A, a singulation unit B, and a delivery unit C, each as a compositional unit (module).

In this embodiment, each of the receiving unit A, singulation unit B, and delivery unit C is attachable, detachable, and exchangeable with other compositional units. Each of the receiving unit A, singulation unit B, and delivery unit C is previously prepared to have a plurality of different specifications according to expected specification requests. In addition, a basic unit 1 includes the receiving unit A, singulation unit B, and delivery unit C.

As illustrated in Fig. 1, the receiving unit A has a pre-stage 2. On this pre-stage 2, a resin encapsulated substrate 3 is received from a resin encapsulating apparatus which is an apparatus used for the previous process. The resin encapsulated substrate 3 corresponds to a resin encapsulated substrate 91 illustrated in Fig. 4. The resin encapsulated substrate 3 is placed on the pre-stage 2 in such a manner that the encapsulating resin 93 illustrated in Fig. 4 is directed downwards. On this pre-stage 2, the alignment of the resin encapsulated substrate 3 is performed according to necessity. On the resin encapsulated substrate 3, as in the case of the resin encapsulated substrate 91 illustrated in Fig. 4, a chip is mounted on each of a plurality of grid areas and a plurality of chips are collectively resin-encapsulated.

The singulation unit B has a cutting table 4. The cutting table 4 is movable in the Y-direction and rotatable in the θ-direction in the figure. On the cutting table 4, a cutting stage 5 is provided. At the back of the singulation unit B, two spindles 6 are provided. These two spindles 6 are independently movable in the X-direction. Each of the two spindles 6 has a rotary blade 7. Each of these rotary blades 7 rotates in the plane along the Y-direction to cut the resin encapsulated substrate 3. Hence, in the present embodiment, a cutting mechanism using the rotary blade 7 is provided in the singulation unit B.

In the delivery unit C, a tray 8 is provided. In the tray 8, each aggregate 9 including a plurality of electronic components singulated in the singulation unit B is received by way of the cutting stage 5 and a main conveying mechanism (not shown). The plurality of electronic components each received in the tray 8 is conveyed to the subsequent process (e.g. an examination process).

In the present embodiment, the main conveying mechanism (not shown) is provided at a position where it is commonly applied to compositional units composed of the receiving unit A, singulation unit B, and delivery unit C. This position is indicated with arrows (bold and solid arrows) extending rightward along the X-direction in Fig. 1.

In the entirety of the present invention, a cutting mechanism other than the rotary blade 7 may be used in the singulation unit B. For example, in the singulation unit B, a cutting mechanism including any one of a laser light, water jet (it may be used with an abrasive), wire saw, and band saw, may be selected and used. For example, in the case where an electronic component having a rectangular planer shape, i.e. an electronic component having only sides formed by segments, is manufactured, a cutting mechanism having a rotary blade 7 or band saw may be used. In the case where an electronic component having a planer shape including a curve, polygonal line, or the like is manufactured, a cutting mechanism having a laser light, water jet, or wire saw may be used.

In the entirety of the present invention, a variety of compositional units can be employed as the delivery unit C. For example, a delivery unit C having the function of receiving a plurality of electronic components in a tray, the function of receiving them in a tube, the function of discretely transferring and delivering them, etc, can be employed.

The characteristics of the singulation apparatus for manufacturing an electronic component S1 according to the present embodiment are as follows: firstly, the singulation apparatus S1 has the receiving unit A, singulation unit B, and delivery unit C as compositional units. Secondly, each of the compositional units is previously prepared to have different plural specifications according to the expected specification requests. Thirdly, each of the compositional units is attachable, detachable, and exchangeable with other compositional units. Fourthly, a main conveying mechanism (not shown) is provided at a position where it is commonly applied to the compositional units composed of the receiving unit A, singulation unit B, and delivery unit C.

In the present embodiment, with such characteristics, it is possible to combine each compositional unit which has been previously prepared to have different plural specifications according to the expected specification requests. Hence, an optimum singulation apparatus in accordance with a user-requested specification is manufactured in a short period of time. Specifically speaking, a singulation apparatus having an optimum cutting mechanism, receiving unit A, and delivery unit C is manufactured in a short period of time. In addition, since the main conveying mechanism (not shown) is provided at a position where it is commonly applied to each compositional unit, the singulation apparatus is manufactured in a short period of time also in view of this configuration. These configurations enable the singulation apparatus optimum for the user to be delivered in a shorter period of time. Furthermore, since unnecessary portions for the user are not included in the singulation apparatus, reducing the footprint and cost of the singulation apparatus becomes possible.

Furthermore, in the entirety of the present invention, it is possible to realize an optimum singulation apparatus by changing each compositional unit to a compositional unit with a different specification in accordance with the change in the market trends, technology trends, etc. For example, in the case where the demand of an electronic component which has a planer shape including a curve, polygonal line, or the like increases, (such as a certain type of memory card), a singulation unit B using a cutting mechanism having a rotary blade 7 may be changed to an appropriate singulation unit B. As the newly mounted singulation unit B, it may be a singulation unit B capable of cutting a target along a curve, polygonal line, or the like. Such a singulation unit B includes, for example, those using a cutting mechanism having a laser light, water jet, or wire saw.

### SECOND EMBODIMENT

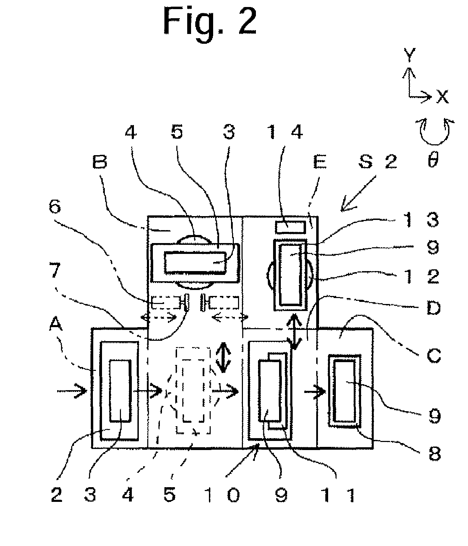

The second embodiment of the singulation apparatus for manufacturing an electronic component according to the present invention will be described with reference to Fig. 2. Fig. 2 is a schematic plain view illustrating the singulation apparatus for manufacturing an electronic component according to this embodiment. As illustrated in Fig. 2, the singulation apparatus for manufacturing an electronic component S2 according to the present embodiment has a receiving unit A, singulation unit B, cleaning unit D, examination unit E, and delivery unit C, each as a compositional unit (module). In the singulation apparatus S2, the cleaning unit D and the examination unit E are provided between the singulation unit B and the delivery unit C in the singulation apparatus S1 illustrated in Fig. 1. In addition, a main conveying mechanism (not shown) is provided at a position to be commonly applied to the receiving unit A, singulation unit B, cleaning unit D, and delivery unit C among the compositional units.

In the present embodiment, each of the receiving unit A, singulation unit B, cleaning unit D, examination unit E, and delivery unit C is attachable, detachable, and exchangeable with other compositional units. Each of the receiving unit A, singulation unit B, cleaning unit D, examination unit E, and delivery unit C is previously prepared to have a plurality of different specifications according to expected specification requests.

Hereinafter, in the singulation apparatus S2 illustrated in Fig. 2, the compositional units different from those of the singulation apparatus S1 illustrated in Fig. 1 will be described. As illustrated in Fig. 2, the cleaning unit D has a cleaning mechanism 10. In the cleaning mechanism 10, a cleaning roller 11 made of a water-absorbing material such as a sponge is provided so that it is rotatable around the axis along the Y-direction. Under the cleaning roller 11, a water tank (not shown) is provided. The cleaning roller 11 rotates while absorbing the water stored in the water tank.

Over the cleaning unit 10, an aggregate 9 composed of a plurality of electronic components (packages) made by cutting the resin encapsulated substrate 3 is placed. The aggregate 9 is absorbed and stabilized by the main conveying mechanism (not shown) at the substrate side (i.e. the obverse side plane of the figure sheet). In other words, the aggregate 9 is absorbed and stabilized at the side of the substate 92 illustrated in Fig. 4. The aggregate 9 absorbed and stabilized by the main conveying mechanism moves in the left to right direction from in the figure. With this movement, the plane of the encapsulating resin side of the aggregate 9 (the reverse side plane of the figure sheet) touches the cleaning roller 11 rotating with the absorbed water. This cleans the plane of the encapsulating resin side of the aggregate 9. After that, air (preferably hot air) is blown across the full width of the cleaned aggregate 9 so as to blow off the water attached to the aggregate 9 and dry the surface of the aggregate 9.

As illustrated in Fig. 2, an examination table 12 is provided in the examination unit E and the examination table 12 is rotatable in the θ-dircction. On the examination table 12, an examination stage 13 is assembled. To the examination stage 13, a plurality of cleaned electronic components are transferred from a sub conveying mechanism (not shown) diverged from the main conveying mechanism which absorbs and stabilizes the aggregate 9 composed of a plurality of electronic components. In Fig. 2, the sub conveying mechanism's movement line between the cleaning unit D and examination unit E is indicated with a bold and solid arrow along the Y-direction.

The examination unit E performs a visual inspection of an electronic component. At the back of the examination unit E, a camera 14 is provided for taking a still image of an electronic component. The camera 14 is movable in the X-direction and Y-direction. The examination unit E has a control unit (not shown). The control unit performs an image processing based on the still image of an electronic component received from the camera 14, and compares the received image data and the previously stored data in order to determine whether the electronic component is defective or nondefective. The control unit memorizes the data (i.e. what is called map data) regarding the defective and nondefective products in the aggregate 9 according to necessity.

In the tray 8 provided in the delivery unit C, an aggregate 9 composed of a plurality of electronic components, which have been singulated by the singulation unit B, cleaned by the cleaning unit D, and examined by the examination unit E, are received by way of the main conveying mechanism (not shown) from the side of the cleaning unit D. In the present embodiment, based on the map data memorized in the control unit (not shown), the nondefective products among the electronic components received in the tray 8 are conveyed to the subsequent process (e.g. a packaging process). Simultaneously, the defective products are received in a defective products tray (not shown).

The characteristics of the singulation apparatus for manufacturing an electronic component S2 according to the present embodiment are as follows: firstly, the singulation apparatus S2 has the receiving unit A, singulation unit B, cleaning unit D, examination unit E, and delivery unit C as compositional units. Secondly, each of the compositional units is previously prepared to have different plural specifications according to the expected specification requests. Thirdly, each of the compositional units is attachable, detachable, and exchangeable with other compositional units. Fourthly, the main conveying mechanism (not shown) is provided at a position where it is commonly applied to the receiving unit A, singulation unit B, cleaning unit D, and delivery unit C, among the compositional units.

In the present embodiment, with such characteristics, it is possible to combine each compositional unit which has been previously prepared to have different plural specifications according to the expected specification requests. Hence, an optimum singulation apparatus in accordance with a user-requested specification is manufactured in a short period of time. Specifically speaking, a singulation apparatus having an optimum cutting mechanism, receiving unit A, cleaning unit D, examination unit E, and delivery unit C is manufactured in a short period of time. In addition, since the main conveying mechanism (not shown) is provided at a position where it is commonly applied to a portion of compositional units, the singulation apparatus is manufactured in a short period of time also in view of this configuration. These configurations enable the singulation apparatus optimum for the user to be delivered in a shorter period of time. Furthermore, since unnecessary portions for the user are not included in the singulation apparatus, reducing the footprint and cost of the singulation apparatus becomes possible. Additionally, it is possible to realize an optimum singulation apparatus by changing each compositional unit to a compositional unit with a different specification in accordance with the change in the market trends, technology trends, etc.

In the present embodiment, in the cleaning unit D, a cleaning process using steam, a cleaner, or other agents may be employed in place of a cleaning process using the cleaning roller 12 and water. In the examination unit E, an electrical inspection or other test may be performed for example in place of a visual inspection (optical inspection).

### THIRD EMBODIMENT

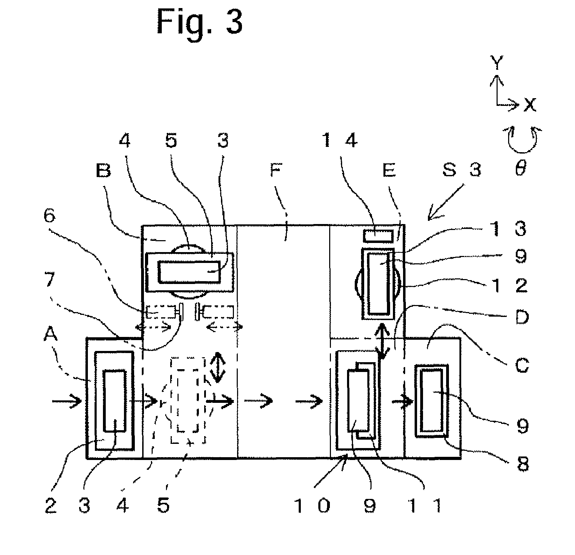

The third embodiment of the singulation apparatus for manufacturing an electronic component according to the present invention will be described with reference to Fig. 3. Fig. 3 is a schematic plain view illustrating the singulation apparatus for manufacturing an electronic component according to this embodiment. As illustrated in Fig. 3, the singulation apparatus for manufacturing an electronic component S3 has a receiving unit A, singulation unit B, option unit F, cleaning unit D, examination unit E, and delivery unit C, each as a compositional unit (module).

As illustrated in Fig. 3, the singulation apparatus for manufacturing an electronic component S3 according to the present embodiment has the option unit F between the singulation unit B, the cleaning unit D, and examination unit E in the singulation apparatus S2 illustrated in Fig. 2. The option unit F includes a mechanism for performing an examination by an Open Short Tester, Debuss for cutting only a lead portion in a QFN (Quad Flat Non-leaded Package), a mechanism for performing an emulsion cleaning, or other mechanism. In addition, a main conveying system is provided at a position where it is commonly applied to the receiving unit A, singulation unit B, option unit F, cleaning unit D, and delivery unit C, among the compositional units.

In the present embodiment, each of the receiving unit A, singulation unit B, option unit F, cleaning unit D, examination unit E, and delivery unit C is attachable, detachable, and exchangeable with other compositional units. Each of the receiving unit A, singulation unit B, cleaning unit D, examination unit E, and delivery unit C is previously prepared to have a plurality of different specifications according to expected specification requests. In addition, the option unit F is prepared in accordance with each user's specific specification request.

The characteristics of the singulation apparatus for manufacturing an electronic component S3 according to the present embodiment are as follows: firstly, the singulation apparatus S2 has the receiving unit A, singulation unit B, option unit F, cleaning unit D, examination unit E, and delivery unit C as compositional units. Secondly, among the compositional units A through F, each of the receiving unit A, singulation unit B, cleaning unit D, examination unit E, and delivery unit C is previously prepared to have different plural specifications according to the expected specification requests, and the option unit F is prepared according to the requested specification by the user. Thirdly, each of the compositional units A through F is attachable, detachable, and exchangeable with other compositional units. Fourthly, the main conveying mechanism (not shown) is provided at a position where it is commonly applied to the receiving unit A, singulation unit B, option unit F, cleaning unit D, and delivery unit C, among the compositional units A through F.

In the present embodiment, with such characteristics, an optimum singulation apparatus in accordance with a specifically requested specification by a user is manufactured in a short period of time. In particular, the receiving unit A, singulation unit B, cleaning unit D, examination unit E, and delivery unit C which have been previously prepared to have a plurality of different specifications are combined, and in addition, the option unit F which has been prepared in accordance with a specifically requested specification by a user is combined. This leads to a rapid manufacturing of a singulation apparatus in accordance with a specifically requested specification by a user, particularly a singulation apparatus having an optimum cutting mechanism, receiving unit A, option unit F, cleaning unit D, examination ) unit E, and delivery unit C. In addition, since the main conveying mechanism (not shown) is provided at a position where it is commonly applied to a portion of the compositional units A through F, the singulation apparatus is manufactured in a short period of time also in view of this configuration. These configurations enable the singulation apparatus having an optimum option unit F for the user to be delivered in a shorter period of time. Furthermore, since unnecessary portions for the user are not included in the singulation apparatus, reducing the footprint and cost of the singulation apparatus becomes possible. Additionally, it is possible to realize an optimum singulation apparatus by changing each of the compositional units A through F to a compositional unit with a different specification in accordance with the change in the market trends, technology trends, etc.

In the present embodiment, the following two modifications may be adopted. In the first modification example, a module having the same cutting mechanism as that of the singulation unit B is mounted as the option unit F. For example, in Fig. 3, a module using a rotary blade 7 similar to that of the singulation unit B may be mounted as the option unit F. Alternatively, a module using a cutting mechanism having one kind among a laser light, water jet, wire saw, and band saw may be selected, and the module of the selected kind may be mounted to both the singulation unit B and option unit F. Accordingly, in the first modification example, it is possible to increase the efficiency in singulation.

In the second modification example, a module using a cutting mechanism different from that of the singulation unit B is mounted as the option unit F. With this modification example, an optimum cutting mechanism can be used in accordance with the property of the resin encapsulated substrate 3 which is to be singulated. For example, in the case where an electronic component having a planer shape including a curve in addition to a straight line is manufactured, a module using a water jet as the option unit F may be selected and mounted in Fig. 3. In this case, the straight line portion is cut by using the rotary blade 7 of the singulation unit B, and the curved portion is cut by using the water jet of the option unit F. In the option unit F, a laser or wire saw may be used in place of a water jet. Accordingly, in the second modification example, it is possible to use an optimum cutting mechanism in accordance with the property of the resin encapsulated substrate 3.

In the second modification example, each of the cutting mechanisms used in the singulation unit B and option unit F may be determined in consideration of the influence of the cutting mechanism upon the resin encapsulated substrate 3. For example, a cutting mechanism having a laser light may be used as the singulation unit B and a cutting mechanism having a water jet may be used as the option unit F. In this case, a substance generated by the melting of the encapsulating resin might adhere to the portion cut (or fused) by using a laser light. This adhered substance (i.e. molten adhered substance) may be removed by using a water jet. In other words, it is possible to perform a finish processing by a water jet. Accordingly, in the second modification example, it is possible to enhance the cutting quality.

In addition to the compositional units A through F which have been explained in the second and third embodiments, another compositional unit may further be mounted. For example, in accordance with the user-requested specification, another examination unit may be mounted to the examination unit E so as to perform another examination for a package by this other examination unit. As this other examination, an electrical inspection, visual inspection for the other side of the side to be examined by the examination unit E, or other examination may be performed.

In each of the modification examples, a total of three or more of the singulation unit B and option unit F may be mounted and a cutting mechanism may be provided to each of them. In this case, it is possible to increase both the efficiency in singulation and the cutting quality.

It should be noted that the present invention is not limited to each previously-described embodiment, and can be at will and appropriately combined, changed or selected according to necessity without a departure from the scope of the present invention.

## Claims

1. A singulation apparatus for manufacturing an electronic component, the singulation apparatus being used for manufacturing a plurality of electronic components by resin-encapsulating semiconductor chips or other elements, each mounted on each of a plurality of areas provided on a substrate, to form a resin encapsulated substrate, and then singulating the resin encapsulated substrate by each area, comprising as compositional units:
a receiving unit for receiving the resin encapsulated substrate;
a singulation unit for singulating the resin encapsulated substrate; and
a delivery unit for delivering the plurality of electronic components formed by singulation,
wherein each of the receiving unit, the singulation unit, and the delivery unit is attachable, detachable, and exchangeable with other compositional units.

2. The singulation apparatus for manufacturing an electronic component according to claim 1, comprising, as a compositional unit, a cleaning unit for cleaning an aggregate composed of a plurality of singulated electronic components, wherein the cleaning unit is attachable, detachable, and exchangeable with other compositional units.

3. The singulation apparatus for manufacturing an electronic component according to claim 1 or 2, comprising, as a compositional unit, an examination unit for examining each of the plurality of the singulated electronic components, wherein the examination unit is attachable, detachable, and exchangeable with other compositional units.

4. The singulation apparatus for manufacturing an electronic component according to any one of claims 1 through 3, comprising a main conveying mechanism, which is placed at a position to be commonly applied to at least a portion of the compositional units, for conveying the resin encapsulated substrate or the aggregate.

5. The singulation apparatus for manufacturing an electronic component according to any one of claims I through 4, wherein:
the singulation unit comprises a cutting mechanism using any one of a rotary blade, laser light, water jet, wire saw, and band saw; and
one or a plurality of the singulation units are included.
